# EUROPEAN PATENT APPLICATION

(11) **EP 1 347 334 A1**
(43) Date of publication of application: **24.09.2003**
(21) Application number: 03251226.1
(22) Date of filing: 28.02.2003
(51) Int. Cl.: G03F 7/004, G03F 7/039

(54) **Photoresist compositions**

(30) Priority: 01.03.2002 US 361124 P
(71) Applicant: Shipley Co. L.L.C., Marlborough, MA 01752 (US)
(72) Inventor: Taylor, Gary N., Northboro, Massachusetts 01532 (US); Teng, Fary Ganghui, Northboro, Massachusetts 01532 (US)
(74) Representative: Kent, Venetia Katherine

(57) **Abstract**

New photoresists are provided that are suitable for short wavelength imaging, including sub-300 nm and sub-200 nm such as 193 nm and 157 nm. Resists of the invention comprise a polymer component that contains one or more adhesion-promoting groups that can impart enhanced adhesion of a coaling layer of a photoresist containing the polymer to an underlying substrate, including a SiON layer.

## Description

### BACKGROUND OF THE INVENTION

### 1. Field of the Invention

The present invention relates to new photoresist compositions that are suitable for short wavelength imaging, including sub-300 nm and sub-200 nm such as 248 nm, 193 nm and 157 nm. Photoresists of the invention can exhibit significant adhesion to SiON and other inorganic surface layers. Preferred photoresists of the invention are characterized hy comprising a polymer, particularly a copolymer that has one or more pendant adhesion-promoting groups that can enhance adhesion to an underlying surface, including an underlying SiON layer.

### 2. Background

Photoresists are photosensitive films used for transfer of images to a substrate. A coating layer of a photoresist is formed on a substrate and the photoresist layer is then exposed through a photomask to a source of activating radiation. The photomask has areas that are opaque to activating radiation and other areas that are transparent to activating radiation Exposure to activating radiation provides a photoinduced chemical transformation of the photoresist coating to thereby transfer the pattern of the photomask to the photoresist-coated substrate. Following exposure, the photoresist is developed to provide a relief image that permits selective processing of a substrate.

A photoresist can be either positive-acting or negative-acting. For most negative-acting photoresists, those coating layer portions that are exposed to activating radiation polymerize or crosslink in a reaction between a photoactive compound and polymerizable reagents of the photoresist composition. Consequently, the exposed coating portions arc rendered less soluble in a developer solution than unexposed portions. For a positive-acting photoresist, exposed portions arc rendered more soluble in a developer solution while areas not exposed remain comparatively less developer soluble.

While currently available photoresists are suitable for many applications, current resists also can exhibit significant shortcomings, particularly in high performance applications such as formation of highly resolved sub-quarter micron and even sub-tenth micron features.

Consequently, interest has increased in photoresists that can be photoimaged with short wavelength radiation, including exposure radiation of below 300 nm such as 248 nm, or even 200 nm or less such as 193 nm. Quite recently, F₂ excimer laser imaging, i.e. radiation having a wavelength of about 157 nm, has been considered as a route to manufacture of even smaller features. See, generally, Kunz, ct al., SPIE Proceedings (Advances in Resist Technology), vol. 3678, pages 13-23 (1999).

Silicon oxynitride (SiON) layers and other inorganics such as Si₃N₄ coatings have been employed in semiconductor device manufacture, for example as an etch stop layer and an inorganic antireflectivc layer. See, for instance, U.S. Patents 6,124,217; 6,153,504; and 6,245,682.

It would be desirable to have new photoresist compositions that could be imaged at short wavelengths such as sub-300 nm and sub-200 nm. It would be particularly desirable to have such photoresists that would provide good resolution on SiON and other inorganic substrate layers.

### SUMMARY OF THE INVENTION

Novel photoresist compositions are provided that comprise an adhesion-promoting polymer component and one or more photoacid generator compounds. Preferred resists of the invention arc useful for short-wavelength imaging, including sub-300 nm and sub-200 nm wavelengths such as 248 nm, 193 nm and 157 nm.

The adhesion-promoting polymer preferably comprises a copolymer that contains one or more pendant groups ("adhesion-promoting groups") that can impart enhanced adhesion of a coating layer of a photoresist containing the polymer to an underlying substrate, including a SiON layer.

We have found that organic antireflective materials may have limited applications at extremely short imaging wavelengths such as sub-170 nm, particularly 157 nm. At such short wavelengths, the antireflective layer is optimally quite thin (e.g. ≤ 30 nm layer thickness). Current organic antireflective compositions have not provided sufficient absorbance at such layer thicknesses. Hence, inorganic antireflective materials such as SiON and Si₃N₄ appear to have greater potential as an antireilective layer for sub-170 nm imaging such as 157 nm.

We also have found that prior photoresists can adhere relatively poorly to such inorganic surface coatings, resulting in reduced resolution of a patterned image.

We have now found that photoresists of the invention can adhere will to such inorganic surface layers, including SiON layers. See, for instance, the comparative data set forth in Example 2, which follows.

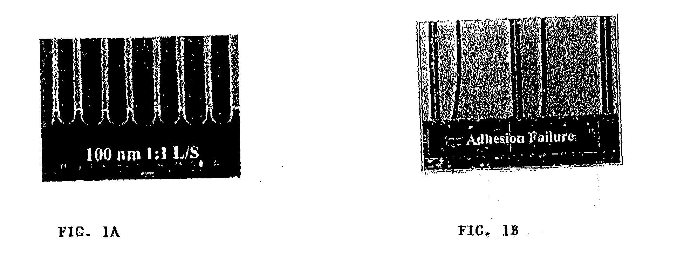

The term adhesion-promoting group or moiety refers to herein a moiety that is incorporated into a resist polymer and provides a discemable increase in adhesion of the resist to a SiON surface layer. A discernable increase in adhesion is indicated by resist to a SiON surface layer. A discernable increase in adhesion is indicated by enhanced resolution relative to a control resist (same resist processed in same manner, but resist resin has not been modified to include the candidate adhesion-promoting groups). Such enhanced resolution is determined by visual inspection of scanning electron micrographs (SEMs) of the resist with candidate adhesion-promoting mojetics (test resist) and the control resist. See, for instance, the clearly discemable difference between the SEMs of FIGS. 1A and 1B. Thus, suitable adhesion-promoting moieties for any given resist system can be readily identified empirically. Preferred adhesion-promoting moieties and polymers are disclosed in detail herein.

Preferred adhesion-promoting polymer groups contain one or more electron-withdrawing atoms and/or moieties, such as halogen (preferably F); fluoroalkyl including fluoro(C₁₋₆alkyl) and perfluoroalkyl such as perfluoro(C₁₋₆alkyl) especially perfluoro(C₁₋ ₃alkyl) e.g. -CF₃, -CF₂CF₃ and the like; nitro; alkanoyl including C₁₋₆alkonyl including formyl and acetyl; hydroxy and hydroxyalkyl (alcohol) such as hydroxy(C₁₋₆alkyl) including hydroxymethyl (HOCH₂-), hydroxyethyl (HOCH₂CH₂- and CH₃CH(OH)-) and the like; etc.

Adhesion-promoting groups may comprise multiple moieties that are electron-withdrawing. For instance, an adhesion-promoting group may comprise an ester group that has fluoro or fluoroalkyl substitution. That is, an adhesion-promoting group may comprise an ester group, e.g. a group of the formula -C(=O)OR, that has further electron-withdrawing substitution, e.g. where R is fluoroalkyl.

Without being bound by any theory, it is believed that moieties that have significant solubilizing effects in aqueous alkaline developer solutions will be less preferred as an adhesion-promoting group. For such reasons, a carboxy or carboxylate group (e.g. -COOH) and amides may be less preferred.

Also, preferred adhesion-promoting groups include those that can exhibit significant hydrogen-bonding properties to various polar moieties of a SiON surface layer. Thus, preferred are adhesion-promoting groups that comprise alcohol (i.e. hydroxyalkyl), fluoroalkyl and other moieties having similar H-bonding characteristics,

Particularly for sub-200 nm imaging, and even more particularly for sub 170 nm imaging such as 157 nm imaging, preferred adhesion-promoting groups will not contain moieties that are significantly absorbing of exposure radiation, e.g. conjugated systems, or for 157 nm imaging, extended alkyl chains such as an alkyl chain having more than about 8 consecutive carbon atoms.

Generally preferred adhesion-promoting polymer groups do not contain phenyl or other aromatic moiety. Particularly preferred adhesion-promoting groups also are substantially inert to typical lithographic (photoresist) processing, i.e. the groups do not undergo a deblocking or covalent bond-breaking reaction during typical lithographic processing of a photoresist containing the polymer, e.g. a pre-exposure soft-bake of up to about 165°C for 1-2 minutes, exposure to activating radiation, post-exposure bake of up to about 110-130°C for 1-2 minutes, and alkaline aqueous development.

A photoresist composition of the invention may comprise a single resin, or a blend of multiple, distinct resins. Generally preferred are resists that contain a single resin. That single resin preferably contains both photoacid-labile groups (e.g. photoacid-labile ester or acetal groups) and adhesion-promoting groups.

Alternatively, although less preferred, a resist composition of the invention may comprise a plurality of distinct resins, e.g. where a first resin comprises photoacid-labile groups but is free or at least essentially free (e.g. less than about 5, 4, 3, 2 or I mole percent based on total polymer units) of adhesion-promoting groups, and a second resin that comprises adhesion-promoting groups but is free or at least essentially free (e.g. less than about 5, 4, 3, 2 or 1 mole percent based on total polymer wits) of photoacid-labile groups.

A resin that comprises adhesion-promoting units suitably will have a weight average molecular weight in excess of about 500 daltons, more preferably a weight average molecular weight of at least about 1,000, 2,000, 3,000, 4,000 or 5,000 daltons. Higher molecular weight materials also will be suitable, e.g. a resin having a weight average molecular weight of about 8,000, 10,000, 15,000 or 20,000 daltons. Resins having weight average molecular weights in excess of about 50,000, 100,000 or 150,000 will be less preferred for at least some applications.

As indicated above, preferred resins that contain adhesion-promoting groups are copolymers, i.e. contain two or more distinct repeat units. Particularly preferred adhesion-promoting copolymers are terpolymers (three distinct repeat units), tetrapolymers (four distinct repeat units) and pentapolymers (five distinct repeat units). As used herein, the term "copolymer" is inclusive of polymers having two distinct repeat units as well as higher order polymers, i.e. polymers that have more than two distinct repeat units such as terpolymers, letrapolymers, pentapolymers, etc.

The repeat units of a polymer used in a resist of the invention may suitably vary depending on the exposure wavelength used for imaging the resist. More particularly, for resist to be imaged at wavelengths greater than 200 nm, the resin may suitably contain aromatic units, particularly optionally substituted phenyl units, preferably phenolic units such as provided by polymerization of a vinylphenol. For resists to be imaged with radiation having a wavelength of less than 200 nm such as 193 nm or 157 nm, the resin suitably may be substantially, essentially or completely free of any phenyl or other aromatic units. A resin that is substantially free of aromatic units has less than about 5 mole percent aromatic units based on total resin units, preferably less than about 4, 3, 2, 1 or 0.5 mole percent aromatic units based on total resin units.

In addition to adhesion-promoting groups, preferred resin units include fluorine-containing moieties, such as may be provided by polymerization of an unsaturaied fluorinated monomer particularly tetrafluorocthylene, or a monomer containing a fluorinated alcohol particularly where the hydroxy is bound to a secondary or tertiary carbon e.g. hexafluoro-iso-propanol (-C(OH)(CF₃)₂).

Additional preferred units of an adhesion-promoting polymer include alicyclic groups, e.g. repeat units that contain a fused alicyclic ring together with repeat units that comprise pendant alicyclic groups.

Unless otherwise indicated, an alicyclic group as referred to herein is inclusive of a group having all carbon ring members as well as group having one or more hetero atoms (e.g. O, S, N or Si, particularly O or S) ring members. A carbon alicyclic group contains all carbon atoms such as e.g. adamantyl, norbornyl, fencyl, pinnanyl, and the like. A heteroalicyclic group contains at least one hetero atom (e.g. O, S, N or Si, parificularly O or S) ring member. Alicyclic groups are understood not to be aromatic.

The invention also includes substrates coated by a photoresist as disclosed herein, including substrates having an inorganic surface coating such as a SiON or Si₃N₄ coating.

Methods for forming relief images also are provided, including methods for forming a highly resolved relief image such as a pattern of lines (dense or isolated) where each line has vertical or essentially vertical sidewalls and a line width of about 0.40 microns or less, or even about 0.25, 0.20, 0.15, or 0.10 microns or less. In such methods, preferably a coating layer of a resist of the invention is imaged with short-wavelength radiation, particularly sub-300 or sub-200 nm radiation, especially 248 nm, 193 nm, and 157 nm radiation, and higher energy radiation such as radiation having a wavelength of less than 100 nm, EUV, electron beam, ion beam or x-ray imaging.

The invention further comprises articles of manufacture comprising substrates such as a microelectronic wafer having coated thereon the photoresists and relief images of the invention. Methods for producing such articles of manufacture also are providing, which generally comprise use of a photoresist of the invention.

Other aspects of the invention are disclosed infra.

### BRIEF DESCRIPTION OF THE DRAWINGS

Figure 1 (which includes FIGS. 1A and 1B) shows scanning electron micrographs (SEMs) of lithographic results of Example 2 which follows.

### DETAILED DESCRIPTION OF THE INVENTION

As discussed above, we now provide new photoresist compositions that comprise one or more photoacid generator compounds and a resin that adhesion-promoting groups that can provide enhanced adhesion to an underlying surface, particularly inorganic coating layers such as those containing SiON and Si₃N₄.

We have discovered that through resist polymer modification adhesion to inorganic surfaces, including SiON and Si₃N₄ surfaces, can be dramatically improved. The modified polymer is preferably the photorenctive resin (deblocking) of a chemically-amplified positive resist. The polymer is modified to include one or more adhesion-promoting moieties or groups.

As discussed above, the adhesion-promoting groups are preferably pendant to the resin backbone, and the resin is preferably a copolymer, with terpolymers, tetrapolymers and pentapolymers being especially suitable. Particularly preferred are adhesion-promoting resins that have fluorine substitution.

Adhesion-promoting resins that have acrylate content also are preferred, including where adhesion-promoting groups(s) are present in polymerized acrylate repeat units. Unless otherwise indicated, references herein to an acrylate are inclusive of substituted acrylates such as methacrylates.

Preferred fluorine-containing units of polymers used in resists of the invention arc suitably derived from at least one ethylenically unsaturated compound. Preferably, such a fluorine substituent is separated from the unsaturated carbons by at least one saturated carbon in order to not unduly inhibit the polymerization reaction. Such fluorinated units may be provided by e.g. polymerization of tetrafluoroethylene, chlorotrifluoroethylene, hexafluoropropylene, trifluoroethylene, vinylidene fluoride, vinyl fluoride, and the like

Exemplary preferred fluorinated unsaturated compounds for synthesis of polymers utilized in resists of the invention include the following of Formulae (A), (B), (C) and (D): 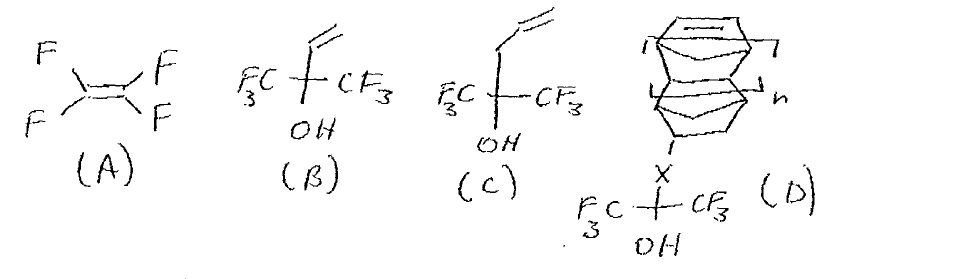 wherein in Formulae (D), X is a linker, preferably -CH₂-, -CH₂OCH₂-, or -OCH₂-; and n is 0 or 1.

Additional preferred monomers for use in a polymer of a resist of the invention may comprise a group of the following formula: 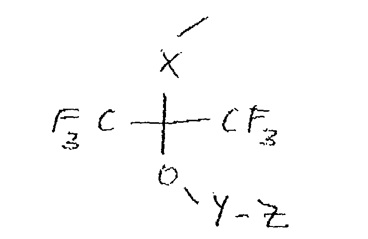 wherein X is a linker, preferably -CH₂-, -CH₂OCH₂-, or -OCH₂-
Y is hydrogen, a chemical bond linking the oxygen and group Z, (-CH₂-)p where p is 1 or 2, -CH₂O-, or CHRO- where R is C₁₋₁₆alkyl, preferably C₁₋₄alkyl; and
Z is alkyl preferably having 1 to about 18 carbons and including tri(C₁₋ ₆)alkylmethyl; tetrahydropyranyl; or tetrahydrofuranyl;
and preferably X is -OCH₂-; preferably Y is a bond or -CH₂O-; and preferably Z is t-butyl, methyl, tetrahydropyranyl, or tetrahydrofuranyl

Resins used in resists of the invention, including adhesion-promoting polymers, also may contain additional units.

Particularly preferred adhesion-promoting polymers used in resists of the invention include those that comprise a structure corresponding to the following Formula I: 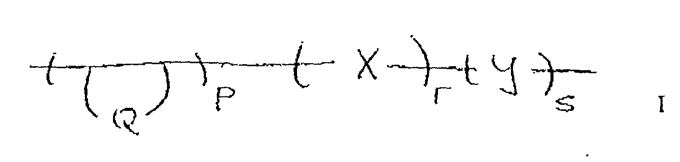 wherein Q represents an optionally substituted carbon alicyclic ring fused to the polymer backbone (i.e. two Q ring members being adjacent carbons of the polymer backbone), the alicyclic ring suitably having 5 to about 18 carbon atoms and is suitably a single ring (e.g. cyclopentyl, cyclohexyl or cyclohcptyl), or more preferably Q is polycyclic e.g. and contain 2 or 3 bridged, fused or otherwise linked rings, and preferred substituents of a substituted Q group include photoacid-labile moieties such as a photoacid-labile ester, or a dissolution-enhancing groups such as -OCH₂C(OH)(CH₃)₂;
X is a group containing one or more fluorine atoms, particularly as may be provided by polymerization of a fluorinated unsaturatcd compound, preferably a fluorinated unsaturated compound such as a compound that has at least one fluorine atom covalently attached to ethylenically unsaturated atom, e.g. tetrafluoroethylene, chlorotrifluoroethylene, hexafluoropropylene, trifluoroethylene, vinylidene fluoride, vinyl fluoride, and the like;
Y comprises an adhesion-promoting moiety as discussed above, e.g. a baloalkyl, hydroxyalkyl, etc. as may be provided e.g. by polymerization of suitable monomers such as ethylhydroxy acrylate, trifluoroethyl acrylate, and the like;
preferably the polymer comprises photoacid-labile groups, and such groups may be a moiety of the above Q, X and Y groups;
p, r and s are mole fractions of the depicted units based on tolal units in the polymer, and p, r and s are each greater than zero.

Particularly preferred adhesion-promoting polymers for use in a resist of the invention has a separate repeat unit that has a photoacid-labile group, such as polymers that comprise a structure corresponding to the following Formula II: 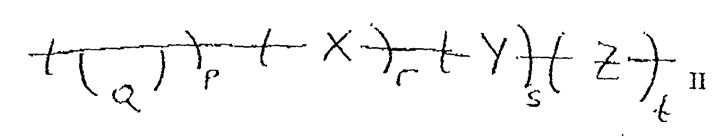 wherein Q, X, Y, p, r and s are the same as defined in Formula I above;
Z is a group that comprises a photoacid-labile group such as a photoacid-labile ester or acetal groups such as may be provided by polymerization of t-butyl acrylate, t-butyl meth acrylate, and the like; and
t is the mole fraction of the depicted photoacid-labile unit based on total units in the polymer, and t is greater than zero.

In polymers of Formula II, suitably units Y that contain adhesion-promoting groups need not contain photoacid-labile group substitution.

Generally preferred adhesion-promoting polymers will contains at least about 2 or 3 mole percent adhesion-promoting units based on total units of the polymer, more preferably at least about 4, 5, 6, 7, 8, 9, 10, 12, 15,20, 25 or 30 mole percent adhesion-promoting units based on total units of (he polymer. Suitably an adhesion-promoting polymer is present in a photoresist composition in an amount of at least about 2, 3 or 4 weight percent based on total solids of the resist composition (all component except solvent), more preferably at least about 5, 6, 7, 8, 10, 12 or 15 weight percent based on total solids of the compositions.

As discussed above, at least one resist component will comprise photoacid-labile units. It is generally preferred that the resin that comprises adhesion-promoting groups also contains photoacid-labile groups, although a separate resin may be employed that contains photoacid-labile groups as discussed above, even if such a multiple resin system is less preferred. Preferred photoacid-labile groups of a resin used in a resist of the invention include photoacid-labile acyclic esters such as a tort-butyl ester, or an ester containing a tertiary alicyclic group. Such photoacid-labile esters may be directly pendant from the resin backbone or other polymer unit such as a carbon alicyclic, heteroalicyclic or other polymer unit (e.g. where the photoacid-labile group is of the formula -C(=O)OR, where R is tert-butyl or other non-cyclic alkyl group, or a tertiary alicyclic group and is directly linked to the polymer backbone or unit), or the ester moieties may be spaced from the polymer backbone or other polymer unit, e.g. by an optionally alkylene linkage (e.g. -(CH₂)₁₋₄C(=O)OR, where R is tert-butyl or other non-cyclic alkyl group, or a tertiary alicyclic group). Such photoacid-labile groups also suitably may contain fluorine substitution at available positions.

Preferred photoacid-labile tertiary alicyclic hydrocarbon ester moietics are polycyclic groups such adamantyl, ethylfencyl or a tricyclodecanyl moiety. References herein to a "tertiary alicyclic ester group" or other similar term indicate that a tertiary alicyclic ring carbon is covalently linked to the ester oxygen, i.e.-C(=O)O-TR' where T is a tertiary ring carbon of alicyclic group R'. In at least many cases, preferably a tertiary ring carbon of the alicyclic moiety will be covalently linked to the ester oxygen. However, the tertiary carbon linked to the ester oxygen also can be exocyclic to the alicyclic ring, typically where the alicyclic ring is one of the substituents of the exocyclic tertiary carbon. Typically, the tertiary carbon linked to the ester oxygen will be substituted by the alicyclic ring itself, and/or one, two or three alkyl groups preferably having 1 to about 5 or 6 carbon atoms. The alicyclic group also preferably will not contain aromatic substitution. The alicyclic groups may be suitably monocyclic, or polycyclic, particularly bicyclic or tricyclic groups.

Preferred alicyclic moieties (e.g. group TR' of -C(=O)O-TR') of photoacid labile ester groups of polymers of the invention have rather large volume. It has been found that such bulky alicyclic groups can provide enhanced resolution when used in copolymers of the invention.

More particularly, preferred alicyclic groups of photoacid labile ester groups will have a molecular volume of at least about 125 or about 130 Å³, more preferably a molecular volume of at least about 135,140, 150, 155, 160, 165, 170, 175, 180, 185, 190, 195, or 200 Å³. Alicyclic groups larger than about 220 or 250 Å³ may be less preferred, in at least some applications. References herein to molecular volumes designate volumetric size as determined by standard computer modeling, which provides optimized chemical bond lengths and angles. A preferred computer program for determining molecular volume as referred to herein is Alchemy 2000, available from Tripos. For a further discussion of computer-based determination of molecular size, see T Omote et al, *Polymers for Advanced Technologies,* volume **4**, pp. 277-287.

Particularly preferred tertiary alicyclic groups of photoacid-labile units include the following, where the wavy line depicts a bond to the carboxyl oxygen of the ester group, and R is suitably optionally substituted alkyl, particularly C₁-₆alkyl such as methyl, ethyl, etc.

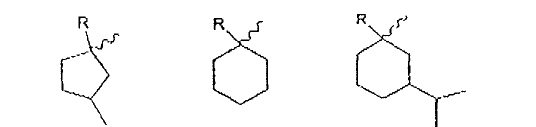

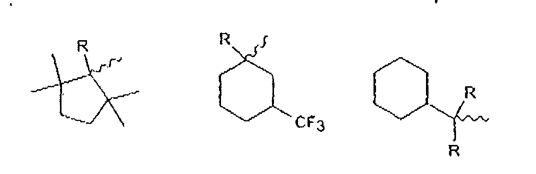

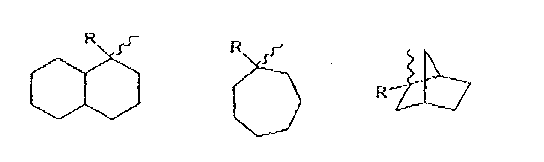

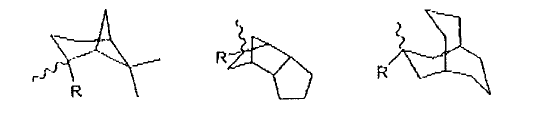

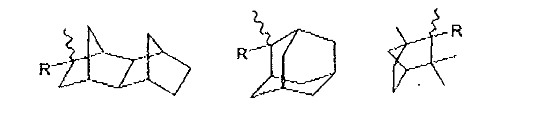

As also indicated above, polymers for use in positive resists of the invention may contain photoacid-labile groups that do not contain an alicyclic moiety. For example, polymers of the invention may contain photoacid-labile ester units, such as a photoacid-labile alkyl ester. Generally, the carboxyl oxygen (i.e. the carboxyl oxygen as underlined as follows: -C(=O)O) of the photoacid-labile ester will be covalently linked to the tertiary carbon. Branched photoacid-labile esters are generally preferred such as t-butyl and -C(CH₃)₂CH(CH₃)₂.

In this regard, polymers used in resists of the invention may contain distinct photoacid-labile groups, i.e. the polymer may contain two or more ester groups that have distinct ester moiety substitutions e.g. one ester may have an alicyclic moiety and another ester may have an acyclic moiety such as t-butyl, or the polymer may contain both ester and other functional groups that are photoacid-labile such as acetals, ketals and/or ethers.

Suitable polymers for use in the resists of the invention also are disclosed in e.g. U.S. Patents 6,306,554; 6,300,035; and 6,165,674, all assigned to the Shipley Company. Those described polymers would be modified in accordance with the invention by incorporating an adhesion-promoting repeat unit in the described polymers. The polymers disclosed in U.S. Patents 6,306,554 and 6,165,674 would he preferred for sub-200 nm imaging, and the polymers described in U.S. Patent 6,300,035 would be preferred for imaging at longer wavelengths such as 248 nm.

As discussed, various resin moieties may be optionally substituted, including groups of Formulae I and II. A "substituted" substituent may be substituted at one or more available positions, typically 1, 2, or 3 positions by one or more suitable groups such as e.g. halogen (particularly F); cyano; C₁₋₆ alkyl; C₁₋₆ alkoxy; C₁₋₆ alkylthio; C₁₋₆ alkylsulfonyl; C₂₋₆ alkenyl; C₂₋₆ alkynyl; hydroxyl; nitro; alkanoyl such as a C₁₋₆ alkanoyl e.g. acyl and the like; etc.

Polymers of the invention can be prepared by a variety of methods. One suitable method is an addition reaction which may include free radical polymerization, e.g., by reaction of selected monomers to provide the various units as discussed above in the presence of a radical initiator under an inert atmosphere (e.g., N₂ or argon) and at elevated temperatures such as about 70°C or greater, although reaction temperatures may vary depending on the reactivity of the particular reagents employed and the boiling point of the reaction solvent (if a solvent is employed). Suitable reaction solvents include e.g. a halogenated solvent such as a fluorinated solvent or a chlorinated solvent and the like. Suitable reaction temperatures for any particular system can be readily determined empirically by those skilled in the art based on the present disclosure. A variety of free radical initiators may be employed. For example, azo compounds may be employed such as azo-bis-2,4-dimethylpentanenitrile. Peroxides, peresters, peracids and persulfates also could be employed.

Other monomers that can be reacted to provide a polymer of the invention can be identified by those skilled in the art. For example, to provide pholoacid-labile units, suitable monomers include e.g. methacrylate or acrylate that contains the appropriate group substitution (e.g. tertiary alicyclic, t-butyl, etc.) on the carboxy oxygen of the ester group. Suitable acrylate monomers with tertiary alicyclic groups for synthesis of polymers useful in the resists of the invention also are disclosed in U.S. Patent 6,306,554 to Barclay et al.

Resist compositions of the invention also comprise one or more photoacid generators (i.e. "PAG") that are suitably employed in an amount sufficient to generate a latent image in a coating layer of the resist upon exposure to activating radiation. Preferred PAGs for imaging at 157 nm, 193 nm and 248 nm imaging include imidosulfonates such as compounds of the following formula: 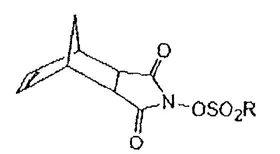 wherein R is camphor, adamantane, alkyl (e.g. C₁₋₁₂ alkyl) and perfluoroalkyl such as perfluoro(C₁₋₁₂alkyl), particularly perfluorooctanesulfonate, perfluorononanesulfonate and the like. A specifically preferred PAG is N-[(perfluorooctanesulfonyl)oxy]-5-norbornene-2,3-dicarboximide.

Sulfonate compounds are also suitable FAGs, particularly sulfonate salts. Two suitable agents for 193 nm and 248 nm imaging arc the following PACES 1 and 2:

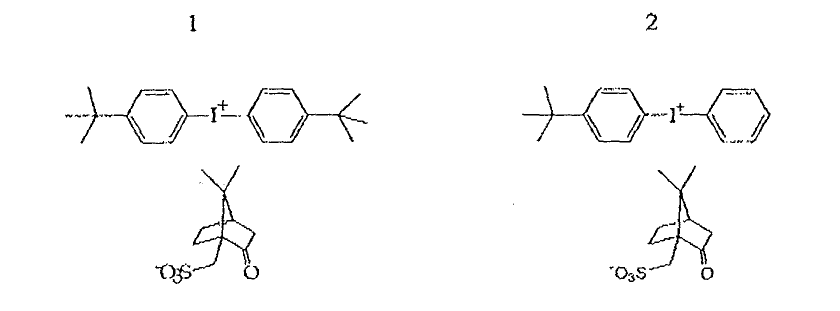

Such sulfonate compounds can be prepared as disclosed in European Patent Application 96118111.2 (publication number 0783136), which details the synthesis of above PAG 1.

Also suitable are the above two iodonium compounds complexed with anions other than the above-depicted camphorsulfonate groups. In particular, preferred anions include those of the formula RSO₃- where R is adamantane, alkyl (c.g. C₁₋₁₂ alkyl) and perfluoroalkyl such as perfluoro (C₁₋₁₂alkyl), particularly perfluorooctanesulfonate, perfluorobutanesulfonate and the like.

For imaging at 157 nm, a triphenyl sulfonium PAG is particularly preferred, complexed with anions such as the sultonate anions mentioned above, particularly a perfluoroalkane sulfonate such as perfluorobutane sulfonate.

A preferred optional additive of resists of the invention is an added base, particularly tetrabutylammonium lactate, which can enhance resolution of a developed resist relief image. Other suitable added bases include diazabicycloundecene or diazabicyclononene. The added base is suitably used in relatively small amounts, e.g. about 0.03 to 5 percent by weight relative to the total solids.

Photoresists of the invention also may contain other optional materials. For example, other optional additives include anti-striation agents, plasticizers, speed enhancers, etc. Such optional additives typically will be present in minor concentrations in a photoresist composition.

The resists of the invention can be readily prepared by those skilled in the art. For example, a photoresist composition of the invention can be prepared by dissolving the components of the photoresist in a suitable solvent such as, for example, 2-heptanone, cyclohexanone, ethyl lactate, propylene glycol monomethyl ether; and propylene glycol monomethyl ether acetate. Typically, the solids content of the composition varies between about 2 and 20 percent by weight of the total weight of the photoresist composition. The resin binder and photoactive components should be present in amounts sufficient to provide a film coating layer and formation of good quality latent and relief images. See the examples which follow for exemplary preferred amounts of resist components.

The compositions of the invention arc used in accordance with generally known procedures. The liquid coating compositions of the invention arc applied to a substrate such as by spinning or other conventional coating technique. When spin coating, the solids content of the coating solution can be adjusted to provide a desired film thickness based upon the specific spinning equipment utilized, the viscosity of the solution, the speed of the spinner and the amount of time allowed for spinning.

The resist compositions of the invention are suitably applied to substrates conventionally used in processes involving coating with photoresists. For example, the composition may be applied over silicon wafers or silicon wafers coated with silicon dioxide, SiON or Si₃N₄ for the production of microprocessors and other microelectronic device substrates.

As discussed above, the photorcsists are Particularly useful for applying over inorganic surface coatings, including SiON and Si₃N₄.

Following coating of the photoresist onto a surface, a resist coaling layer is suitably dried by heating to remove the solvent until preferably the photoresist coating is at least essentially free of solvent. Thereafter, it is imaged through a mask in conventional manner. The exposure is sufficient to effectively activate the photoactive component of the photoresist system to produce a patterned image in the resist coating layer and, more specifically, the exposure energy typically ranges from about I to 100 mJ/cm², dependent upon the exposure tool, radiation type and the components of the photoresist composition.

As discussed above, coating layers of the resist compositions of the invention are preferably photoactivated by a short exposure wavelength, particularly a sub-300 and sub-200 nm exposure wavelength. 193 nm and 157 nm are preferred exposure wavelengths. however, the resist compositions of the invention also may be suitably imaged at higher wavelengths.

Following exposure, the film layer of the composition is preferably baked at temperatures ranging from about 70°C to about 160°C. Thereafter, the film is developed. The exposed resist film is rendered positive working by employing an aqueous based developer such as quaternary ammonium hydroxide solutions such as a tetraalkyl ammonium hydroxide solution, preferably a 0.26 N tetramethylammonium hydroxide aqueous solution; or various amine aqueous solutions such as a solution containing ethyl amine, n-propyl amine, diethyl amine, di-n-propyl amine, triethyl amine; or methyldiethyl amine; alcohol amines such as diethanol amine or triethanol amine; cyclic amines such as pyrrole, pyridine, etc. In general, development is in accordance with procedures recognized in the art.

Following development of the photoresist coating over the substrate, the developed substrate may be selectively processed on those areas bared of resist, for example by chemically etching or plating substrate areas bared of resist in accordance with procedures known in the art. For the manufacture of microelectronic substrates, e.g., the manufacture of silicon dioxide wafers, suitable etchants include a gas etchant, e.g. a halogen plasma etchant such as a chlorine or fluorine-based etchant such a Cl₂ or CF₄/CHF₃ etchant applied as a plasma stream. After such processing, resist may be removed from the processed substrate using known stripping procedures.

All documents mentioned herein are incorporated herein by reference. The following non-limiting examples arc illustrative of the invention.

### Example 1: Polymer synthesis

An adhesion-promoting tetrapolymer polymer was prepared by reaction of 1) norbomene having a ring substituent of-OCII₂C(OH)(CF₃)₂; 2) tetrafluoroethylene (TFE); 3) t-butyl acrylate (photoacid labile group); and 4) 2-hydroxyethyl acrylate (non-photoacid-labile, adhesion-promoting group).

The resulting polymer contained units of the substituted norbomene in an amount of 45 mole percent based on total polymer units, tetrafluoroethylene units in an amount of 30 mole percent based on total polymer units, t-butylacrylate units in an amount of about 20 mole percent based on total polymer units, and 2-hydroxyethyl acrylate in an amount of about 5 mole percent based on total polymer units.

### Example 2: Preparation and lithographic processing of a resist of the invention.

A resist of the invention was prepared by admixing the following components where amounts are expressed as weight percent of solids (all components except solvent) and the resist is formulated as an 84.4 weight percent fluid formulation:

| Component | Amount |
|---|---|
| Resin | 10 |
| PAG | 5.2 |
| Basic Additive | 0.3 |
| Surfactant | 0.1 |
| Solvent | to 84.4 percent formulation |

In the resist, the resin is the polymer prepared in Example 1 . The PAG is triphenylsulfonium perfluorobutane sulfonate The basic additive is tetrabutylammonium lactate. The surfactant is R08. The solvent is 2-heptanone.

The formulated resist composition is spin coated onto 8 inch silicon wafers having an antireflective SiON surface coating. The applied resist is softbaked via a vacuum hotplate at 120°C for 90 seconds The resist coating layer is exposed through a photomask at 157 nm, and then the exposed Si wafer is post-exposure baked at 105°C. The imaged resist layer is then developed by treatment with an aqueous 0.26 N tetramethylammonium hydroxide solution. The resulting photoresist relief image is shown in FIG. 1A.

A comparative photoresist formulation was prepared having the same composition as described immediately I) norbomene having a ring substituent of -OCH₂C(OH)(CF₃)₂; 2) tetrafluoroethylene (TFE); and 3) t-butyl acrylate (photoacid labile group). The terpolymer did not contain the further polymer units with adhesion-promoting units. The comparative photoresist formulation was processed on SiON coated wafers in the same manner as described immediately above in this example. The photoresist image resulting after development is shown in FIG. 1B.

### Example 3: Preparation and lithographic processing of a further resist of the invention.

A resist of the invention was prepared by admixing the following components where amounts arc expressed as weight percent of solids (all components except solvent) and the resist is formulated as an 84.4 weight percent fluid formulation:

| Component | Amount |
|---|---|
| Resin | 10 |
| PAG | 5.2 |
| Basic Additive | 0.3 |
| Surfactant | 0.1 |
| Solvent | to 84.4 |

In the resist, the resin is the same as the polymer prepared in Example 1, except 2,2,2-trifluorocthylacrylate is used in place of the 2-hydroxyethyl acrylale. All other resist components are the same as described in Example 2.

The resulting resist is processed in the same manner as described in Example 2 above.

The foregoing description of the invention is merely illustrative thereof, and it is understood that variations and modifications can be effected without departing from the spirit or scope of the invention as set forth in the following claims.

## Claims

1. A microelectronic device substrate comprising
a silicon oxynitride layer,
a photoresist composition coating layer over the silicon oxynitride layer,
wherein the photoresist composition comprises a polymer and one or more photoacid generator compounds, the polymer comprising one or more adhesion-promoting groups.

2. The substrate of claim 1 wherein the polymer is a copolymer.

3. The substrate of claim 1 or 2 wherein the polymer is a terpolymer, tetrapolymer or pentapolymer.

4. The substrate of any one of claims 1 through 3 wherein the polymer has fluorine substitution.

5. The substrate of any one of claims 1 through 4 wherein the polymer comprises polymerized tetrafluorethylene units.

6. The substrate of any one of claims 1 through 5 wherein the polymer comprises acrylale repeat units.

7. The substrate of any one of claims 1 through 6 wherein an acrylate repeat unit of the polymer comprises an adhesion-promoting group.

8. The substrate of claim 7 wherein the acrylatc unit with an adhesion-promoting group is substantially non-reactive to lithographic processing.

9. The substrate of any one of claims 1 through 7 wherein the polymer comprises a repeat unit that comprises an adhesion-promoting group and the repeat unit is reactive to lithographic processing.

10. The substrate of any one of claims 1 through 9 wherein the adhesion-promoting group comprises a hydroxy moiety.

11. The substrate of any one of claims 1 through 10 wherein the adhesion-promoting group comprises a fluoroalkyl moiety.

12. The substrate of any one of claims 1 through 11 wherein the polymer comprises aromatic groups.

13. The substrate of any one of claims 1 through 11 wherein the polymer comprises phenolic groups.

14. The substrate of any one of claims 1 through 11 wherein the polymer is at least substantially free of any aromatic groups.

15. The substrate of any one of claims 1 through 13 wherein the polymer comprises a structure corresponding to the following Formula I: 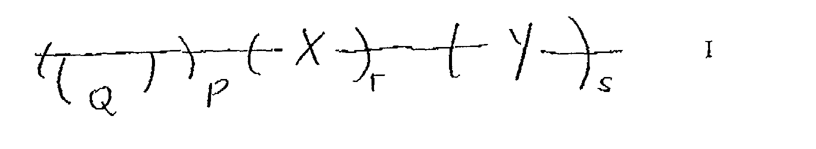 wherein Q represents an optionally substituted carbon alicyclic ring fused to the polymer backbone;
X is a group containing one or more fluorine atoms;
Y is a groups that comprising an adhesion-promoting moiety; and
p, r and s are mole fractions of the depicted units based on total units in the polymer, and p, r and s are each greater than zero.

16. The substrate of any one of claims 1 through 14 wherein the polymer comprises a structure corresponding to the following Formula II; 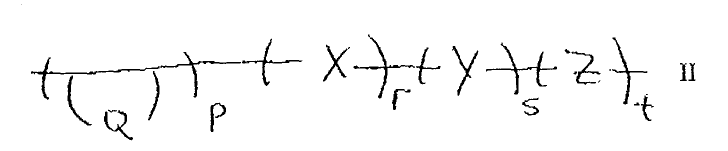 wherein Q represents an optionally substituted carbon alicyclic ring fused to the polymer backbone;
X is a group containing one or more fluorine atoms;
Y is a non-photoacid-labile group that comprises an adhesion-promoting moiety; Z comprises a photoacid-labile group; and
p, r, s, and t are mole fractions of the depicted units based on total units in the polymer, and p, r, s and t are each greater than zero.

17. A microelectronic device substrate comprising
a photoresist composition coating layer over the substrate surface,
wherein the photoresist composition comprises a copolymer and one or more photoacid generator compounds, the copolymer comprising fluorinated repeat units, photoacid labile repeat units, and repeat units that contain an adhesion-promoting moiety.

18. A method for forming a photoresist relief image comprising:
applying a coating layer of a photoresist composition on a substrate, the photoresist composition comprises a copolymer and one or more photoacid generator compounds, the copolymer comprising fluorinated repeat units, photoacid labile repeat units, and repeat units that contain an adhesion-promoting moiety;
exposing the applied photoresist layer to activating patterned radiation and developing the exposed photoresist layer to provide a photoresist relief image.

19. The method of claim 18 wherein the applied photoresist layer is exposed to radiation having a wavelength of less than 300 nm.

20. The method of claim 18 wherein the applied photoresist layer is exposed to radiation having a wavelength of about 248 nm.

21. The method of claim 18 wherein the applied photoresist layer is exposed to radiation having a wavelength of less than 200 nm.

22. The method of claim 18 wherein the applied photoresist layer is exposed to radiation having a wavelength of about 193 nm or 157 nm.

23. The method of any one of claims 18 through 22 wherein the polymer is a copolymer.

24. The method of any one of claims 18 through 23 wherein the polymer is a terpolymer, tetrapolymer or pentapolymer.

25. The method of any one of claims 18 through 24 wherein the polymer comprises polymerized tetrafluorethyl ene units.

26. The method of any one of claims 18 through 25 wherein the polymer comprises polymerized acrylate units.

27. The method of any one of claims 18 through 26 wherein the adhesion-promoting group is a substituent of a polymerized acrylate unit.

28. The method of claim 27 wherein the acrylale unit with adhesion-promoting group is substantially non-reactive to lithographic processing.

29. The method of any one of claims 18 through 28 wherein the adhesion-promoting group comprises a hydroxy moiety.

30. The method of any one of claims 18 through 28 wherein the adhesion-promoting group comprises a fluoroalkyl moiety.

31. The method of any one of claims 18 through 30 wherein the polymer comprises aromatic groups.

32. The method of any one of claims 18 through 30 wherein the polymer comprises phenolic groups.

33. The method of any one of claims 18 through 30 wherein the polymer is at least substantially free of any aromatic groups,

34. The method of any one of claims 18 through 33 wherein the polymer comprises a structure corresponding to the following Formula I: 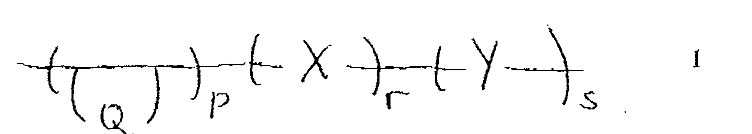 wherein Q represents an optionally substituted carbon alicyclic ring fused to the polymer backbone;
X is a group containing one or more fluorine atoms;
Y is comprises an adhesion-promoting moiety; and
p, r and s are mole fractions of the depicted units based on total units in the polymer, and p, r and s are each greater than zero.

35. The method of any one of claims 18 through 33 wherein the polymer comprises a stricture corresponding to the following Formula II: 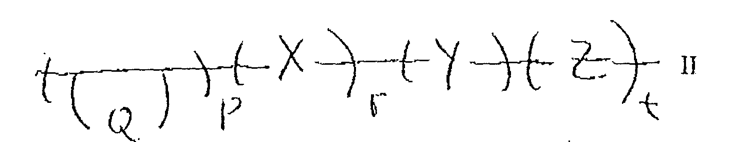 wherein Q represents an optionally substituted carbon alicyclic ring fused to the polymer backbone;
X is a group containing one or more fluorine atoms;
Y is a non-photoacid-labile group that comprises an adhesion-promoting moiety; Z comprises a photoacid-labile group; and
p, r, s, and t are mole fractions of the depicted units based on total units in the polymer, and p, r, s and t are each greater than zero.

36. A photoresist composition comprising one or more photoacid generator compounds and a copolymer comprising fluorinated repeat units, photoacid labile repeat units, *and* repeat units that contain an adhesion-promoting moiety.

37. The photoresist composition of claim 36 wherein the copolymer is a terpolymer, tetrapolymer or pentapolymer.

38. The photoresist composition of claim 36 or 37 wherein the copolymer has fluorine substitution.

39. The photoresist composition of any one claims 36 through 38 wherein the copolymer comprises polymerized tetrafluorethylene units.

40. The photoresist composition of any one of claims 36 through 39 wherein the copolymer comprises acrylate repeat units.

41. The photoresist composition of any one of claims 36 through 40 wherein the adhesion-promoting group is a substituent of an acrylate unit.

42. The photoresist composition of any one of claims 36 through 41 wherein the adhesion-promoting group comprises a hydroxy moiely.

43. The photoresist composition of any one of claims 36 through 42 wherein the adhesion-promoting group comprises a fluoroalkyl moiety.

44. The photoresist composition of any one of claims 36 through 43 wherein the copolymer comprises aromatic groups.

45. The photoresist composition of any one of claims 36 through 43 wherein the polymer comprises phenolic groups.

46. The photoresist composition of any one of claims 36 through 43 wherein the polymer is at least substantially free of any aromatic groups.

47. The photoresist composition of any one of claims 36 through 46 wherein the polymer comprises a structure corresponding to the following Formula I: 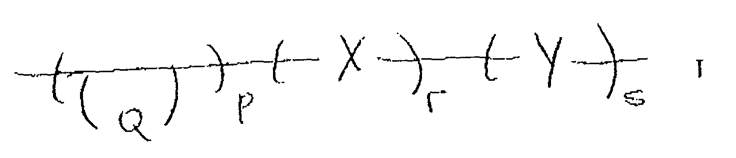 wherein Q represents an optionally substituted carbon alicyclic ring fused to the polymer backbone;
X is a group containing one or more fluorine atoms;
Y comprises an adhesion-promoting moiety; and
p, r and s are mole fractions of the depicted units based on total units in the polymer, and p, r and s are each greater than zero.

48. The photoresist composition of any one of claims 36 through 46 wherein the polymer comprises a structure corresponding to the following Formula II: 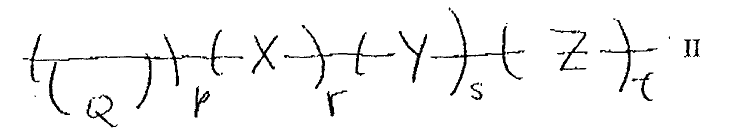 wherein Q represents an optionally substituted carbon alicyclic ring fused to the polymer backbone;
X is a group containing one or more fluorine atoms;
Y comprises an adhesion-promoting moiety;
Z comprises a photoacid-labile group; and
p, r, s, and t are mole fractions of the depicted units based on total units in the polymer, and p, r, s and t are each greater than zero.

49. An article of maim fact lire comprising a substrate having a coaling layer thereon of a photoresist composition of any one of claims 36 though 48.

50. The article of claim 49 wherein the substrate is a microelectronic wafer substrate.

51. The article of claim 49 wherein the substrate is an optical-electronic device substrate.
